# FASCICULE DE BREVET EUROPEEN

(11) **EP 0 419 371 B1**
(45) Date de publication et mention de la délivrance du brevet: **22.09.1993**
(21) Numéro de dépôt: 90420370.0
(22) Date de dépôt: 07.08.1990
(51) Int. Cl.: G01J 5/06

(54) **Dispositif de détection infrarouge**
Vorrichtung zum Infrarotnachweis
Device for infrared detection

(30) Priorité: 22.08.1989 FR 8911287
(43) Date de publication de la demande: 27.03.1991
(73) Titulaire: SOCIETE FRANCAISE DE DETECTEURS, INFRAROUGES- SOFRADIR, F-92290 Chatenay Malabry (FR)
(72) Inventeur: Montanari, Jean Louis, F-38320 Herbeys (FR)
(74) Mandataire: Laurent, Michel

(56) Documents cités:
- US-A- 3 259 865
- PATENT ABSTRACTS OF JAPAN, vol. 6, no. 168 (P-139)[1046], 2 septembre 1982; & JP-A-57 86 016 (FUJITSU) 28-05-1982
- PATENT ABSTRACTS OF JAPAN, vol. 6, no. 136 (E-120)[1014], 23 juillet 1982; & JP-A-57 62 569 (FUJITSU K.K.) 15-04-1982
- PATENT ABSTRACTS OF JAPAN, vol. 10, no. 330 (P-514)[2386], 11 novembre 1986; & JP-A-61 137 028 (TOSHIBA CORP.) 24-06-1986
- PATENT ABSTRACTS OF JAPAN, vol. 6, no. 245 (P-159)[1123], 3 décembre 1982; & JP-A-57 142 526 (FUJITSU K.K.) 03-09-1982
- PATENT ABSTRACTS OF JAPAN, vol. 13, no. 256 (P-884)[3604], 14 juin 1989; & JP-A-1 53 120 (FUJITSU) 01-03-1989

## Description

La présente invention concerne un dispositif de détection infrarouge fonctionnant à basse température. Par "basse température", on entend au sens de l'invention des températures comprises entre 50 et 130 Kelvins (K).

De tels dispositifs de détection infrarouge fonctionnant à basse température sont généralement associés à une enceinte cryostatique (cryostat) contenant selon la température d'utilisation de l'hélium ou de l'azote liquide ou un dispositif cryogénérateur. Le dispositif de détection proprement dit est constitué d'une pluralité de détecteurs unitaires, dénommés photosites, élaborés collectivement par les techniques de la micro-électronique sur un matériau semi-conducteur sensible au rayonnement infrarouge. De tels matériaux connus par ailleurs sont le plus fréquemment constitués par les alliages ternaires semi-conducteurs de formule générale CdₓHg_{o,5-x}Te_{o,5}, où x est compris entre 0 et 0,5.

Ces détecteurs sont en échange thermique avec le cryostat et ce par l'intermédiaire d'un doigt froid.

L'exploitation des rayonnements photoniques détectés s'effectue au moyen d'un circuit de lecture associé au détecteur proprement dit, également en échange thermique avec le cryostat.

Les connexions entre les détecteurs proprement dit et le circuit de lecture et d'exploitation s'effectuent généralement par des câbles de connexion voire par une soudure collective au moyen de microbilles d'indium.

Cette dernière technique, domaine d'application privilégié de l'invention, rend possible l'éclairement des circuits de détection par leur face arrière, évitant de fait l'utilisation de toute connectique encombrante et peu pratique d'utilisation.

Un tel assemblage, constitué du circuit de detection connecté au circuit de lecture est dénommé dans la suite de la description bloc de detection.

Compte tenu de la structure de tels dispositifs de détection infrarouge, les détecteurs sont généralement associés à un écran froid perçé d'une fenêtre jouant le rôle de diaphragme, et ce afin de limiter les réflexions parasites générées soit par les parties chaudes du cryostat soit par le rayonnement utile lui-même, après qu'il ait subi des réflexions et/ou des réfractions sur et dans les matériaux du circuit de détection et du circuit d'exploitation. De tels rayonnements génèrent, lorsqu' ils atteignent les photosites, des signaux électriques incohérents pénalisant de fait les performances électro-optiques du système qui, en l'absence de tels rayonnements parasites approcheraient la précision théorique.

De manière plus précise, ces rayonnements parasites ont pour origine principale, la réflexion sur les pistes métalliques des connexions électriques, sur la surface même du circuit de détection du fait des inévitables imperfections de traitement anti-reflet sur la surface dudit circuit de détection.

Comme déja dit, l'utilisation d'un écran-diaphragme pour la limitation de ces phénomènes permet de limiter le rayonnement latéral. Toutefois, il doit impérativement être porté à basse température et donc être relié au doigt froid du cryostat afin de limiter son propre rayonnement, ce qui suppose donc une liaison tant mécanique que thermique.

Une telle réalisation est décrite dans la demande de brevet déposée par le Demandeur sous le n° 88 10814 et non encore publiée à la date de dépôt de la présente demande.

Si certes l'utilisation d'un écran-diaphragme froid permet une limitation du rayonnement parasite, en revanche, elle présente un certain nombre d'inconvénients. On peut tout d'abord citer le fait que la réalisation de telles pièces par des moyens mécaniques, mêmes élaborés ne permet pas de réaliser des ouvertures des diaphragmes aussi petites et aussi bien positionnées que cela serait souhaitable, compte tenu des dimensions des détecteurs. De plus, l'assemblage mécanique de l'écran au doigt froid du cryostat s'avère particulièrement délicat compte tenu que l'ouverture du diaphragme se situe à proximité de la face arrière du circuit de détection. Cela implique de donner à cette ouverture des dimensions conséquentes compte tenu que le détecteur est en général positionné sur un circuit de lecture généralement associé à une céramique destinée à assurer la connectique. C'est cette dernière qui est elle-même assujettie au doigt froid. Ainsi, il est nécessaire de prendre en compte l'accumulation des tolérances tant latérales que verticales pour dimensionner suffisamment l'ouverture, afin de ne pas occulter une partie du rayonnement utile. Il en résulte donc une efficacité limitée, tant par la dimension d'une telle ouverture que par l'inévitable espace séparant l'écran de la face arrière du circuit de détection.

De plus, compte tenu de la distance séparant l'écran du doigt froid ainsi que de la nécessité de fixer ledit écran mécaniquement à ce dernier, il en résulte des dimensions qui rendent particulièrement difficile non seulement l'abaissement rapide en température de l'écran, mais également l'obtention d'une température d'écran aussi voisine que possible de celle du détecteur, même en utilisant des matériaux présentant une bonne conductibilité thermique. En outre, la nécessité de le fixer mécaniquement au doigt froid du cryostat occulte partiellement les possibilités latérales de connectique. Enfin, compte tenu des dimensions et corrélativement de la masse de cet écran, l'utilisation de ce type de dispositif est impossible aux fortes accélérations en raison des déformations et vibrations inévitablement induites.

La présente invention vise à pallier ces inconvénients. Elle vise un dispositif de détection infrarouge muni d'un écran-diaphragme apte à prémunir ledit dispositif de rayonnement de parasite, mentionné ci-dessus, sans engendrer pour autant les inconvénients énumérés.

La présente invention concerne un dispositif de détection infrarouge fonctionnant à basse température comprenant :
- un cryostat muni d'un doigt froid destiné à assurer un échange thermique avec une source froide ;
- un plan froid disposé de manière générale perpendiculairement par rapport au doigt froid et en relation d'échange thermique avec ce dernier ;
- un circuit de lecture associé à un circuit de connexion, fixé au-dessus dudit plan froid, et en relation d'échange thermique avec ce dernier ;
- un circuit de détection, parallèle audit circuit de lecture et connecté électriquement et thermiquement à ce dernier au moyen de microbilles d'Indium ;
- un écran muni d'une fenêtre formant diaphragme situé entre le circuit de détection et la source de rayonnement infrarouge à détecter.

Ce dispositif de détection infrarouge se caractérise en ce que l'écran est plaqué contre le circuit de détection et est en relation d'échange thermique, uniquement avec ce dernier.

En d'autres termes, la présente invention vise à réduire la distance séparant le diaphragme de l'écran avec la face arrière du circuit de détection à une distance nulle ou quasi nulle par fixation appropriée de l'écran sur ledit circuit de détection, annulant de fait d'une part, les inconvénients liés à la fixation mécanique des écrans connus jusqu'alors et d'autre part, les rayonnements parasites provenant des réflexions et autres réfractions sur le trajet séparant le diaphragme du détecteur.

Avantageusement en pratique :
- l'écran est positionné sur le circuit de détection par encastrement étroit sur les chants dudit circuit ;
- l'assujettissement de l'écran sur le circuit de détection est effectué par collage ;
- l'écran est formé par électroformage d'un métal unique ;
- l'écran présente une structure composite réalisée par électroformage de deux ou plusieurs métaux ; la technique d'électroformage étant apte à la fabrication de pièces de faibles dimensions, se révèle particulièrement adaptée pour la réalisation d'écran conforme à l'invention. En effet, l'assujettissement sur le circuit de détection d'un écran réalisé par méthode mécanique, donc notablement plus lourd, hypothèquerait la mise en oeuvre de l'invention et à tout le moins son utilisation ;
- l'écran est noirci par anodisation, par peinture ou par revettement d'un matériau approprié .

La manière dont l'invention peut être réalisée et les avantages qui en découlent ressortiront mieux de l'exemple de réalisation qui suit, donné à titre indicatif et non limitatif à l'appui des figures annexées.

La figure 1 est une vue en coupe d 'un dispositif de détection de l'art antérieur et plus spécifiquement conformément au document FR-A-2 629 912 du Demandeur.

La figure 2 est une vue en coupe similaire du dispositif de détection conforme à l'invention.

La figure 3 est une vue sommaire en perspective représentant le détail du positionnement de l'écran sur le circuit de détection.

La figure 4 est une vue en coupe selon la ligne IV-IV de la figure 3.

De manière connue, un dispositif de détection infrarouge est enfermé dans une enceinte cryostatique non représentée. Une telle enceinte comprend d'une part une enveloppe extérieure métallique pourvue sur l'une de ses faces d'une fenêtre optique, notamment transparente aux rayons infrarouges et réalisée par exemple en germanium, fermant ladite enceinte et ouverte de l'autre côté, et d'autre part un manchon de refroidissement disposé coaxialement à l'intérieur de l'enceinte. Ce manchon comporte essentiellement deux parties, respectivement une partie extérieure destinée à recevoir un cryogénérateur, par exemple un gaz liquide tel de l'azote ou de l'hélium, en fonction de la température d'utilisation désirée, et une partie intérieure formant doigt froid, se présentant sous la forme d'un tube destiné à contenir le plongeur du cryogénérateur. L'enceinte extérieure et le doigt froid sont assemblées de façon étanche et constituent de fait un vase Dewar placé sous vide.

Le doigt froid (1) est surmonté à son extrémité supérieure, à l'intérieur du cryostat décrit, d'un plan froid (2) perpendiculaire au doigt froid. Ce plan froid est réalisé en un matériau conducteur de la chaleur à basse température, c'est-à-dire un matériau ayant une conductibilité thermique supérieure à 1 Watt.centimètre. Kelvin (W.cm.K) dans la zone de température précitée. Avantageusement, le plan froid est réalisé en un matériau céramique, par exemple en alumine, voire éventuellement en métal.

Ce plan froid (2) est surmonté d'une autre plaque céramique (3) sur laquelle est déposé le bloc de détection (8,9,10), et qui permet d'établir les connections électriques entre ce dernier et le réseau de conducteur du cryostat par l'intermédiaire, par exemple d'un réseau de pistes conductrices sérigraphiées sur cette céramique.

La plaque de connectique (3) est surmontée d'un circuit de lecture et d'exploitation (8).

Enfin, l'ensemble est surmonté du circuit de détection proprement dit (9) connecté électriquement et thermiquement aux circuits de lecture et d'exploitation au moyen de micro-billes d'Indium (10).

Ainsi, ces différents éléments étant en contact étroit et étant constitués pour la plupart de matériaux conducteurs de la chaleur, leur température est très voisine de celle du doigt froid.

Les plots métalliques (6) sont en liaison par des fils de soudure (11) avec les différents plots de contacts électriques du circuit de lecture et d'exploitation.

De manière fondamentale, un écran froid (12), constitué par un cadre métallique continu situé entre le circuit de détection et la fenêtre transparente aux infra-rouges de l'enceinte cryostatique, est solidarisé mécaniquement et thermiquement au plan froid (2). Le cadre métallique (12) présente par une fenêtre de section rectangulaire par exemple, jouant le rôle de diaphragme. Comme déjà dit, le diaphragme est destiné à limiter les rayonnements parasites principalement issus des parois chaudes du cryostat et des réflexions du rayonnement utile sur les surfaces réfléchissantes (plots métalliques de connectique, etc.).

La description précédente se rapporte à l'art antérieur et montre de manière évidente, que malgré l'utilisation d'un matériau bon conducteur de la chaleur pour le diaphragme (12), il existe une différence de température substantielle entre l'extrémité (13) du diaphragme et le doigt froid (1). Cette différence de température engendre une émission de rayonnements parasites par le diaphragme détectés par le circuit de détection (9), induisant des altérations au niveau de la restitution. De plus et comme déjà dit, compte tenu de la relative compléxité de l'ensemble de détection à savoir les détecteurs infrarouges proprement dits, les circuits de lecture et d'exploitation, la plaque de connectique et le plan froid, il se crée par construction un certain nombre d'erreurs liées aux tolérances qui s'ajoutent et peuvent provoquer de fait une occultation partielle du rayonnement utile si l'on n'a pris soin de surdimensionner l'ouverture. Toutefois, cette ouverture plus grande que celle nécessitée par un positionnement idéal perd de son efficacité, tout comme l'écran par la nécessité de se trouver à quelques distances de la face arrière du circuit de détection (9).

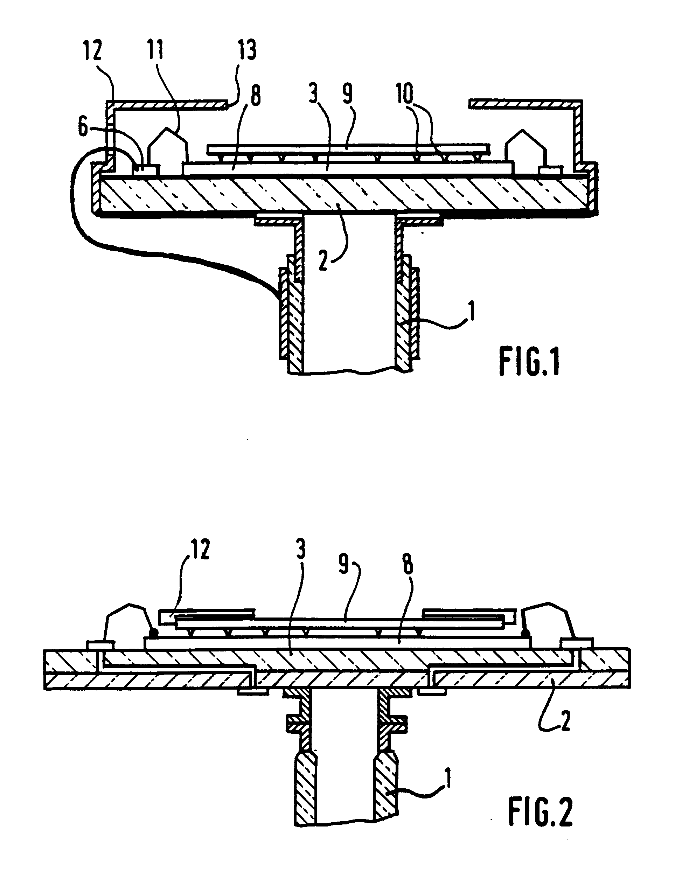

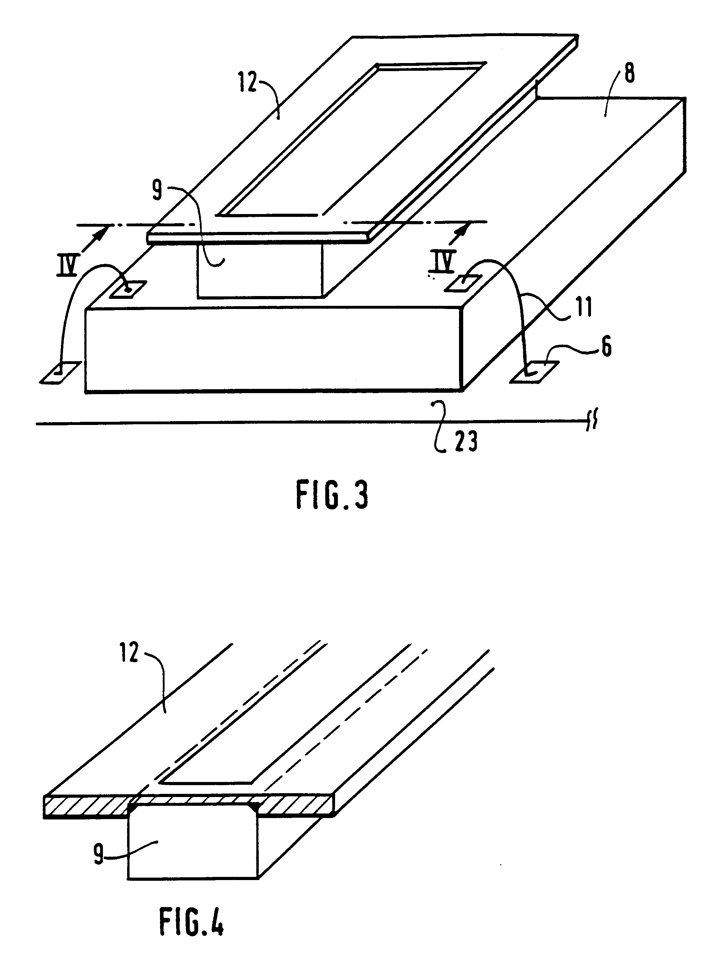

La figure 2 est une vue similaire à la figure 1 mais dans laquelle on a représenté le diaphragme conforme à l'invention. Comme on peut le voir sur cette figure, le diaphragme (12) est encastré sur le détecteur (9). Cet encastrement du diaphragme sur le détecteur est lui-même représenté au sein des figures 3 et 4. Un épaulement est ménagé au niveau du bord interne de l'écran (12) destiné à s'appuyer sur le bord du détecteur (9). L'assujettissement et la solidarisation de l'écran-diaphragme sur le détecteur (9) s'effectuent par collage, par exemple au moyen de la colle du type EPO-TEK H70E.

Comme on peut le voir en détail au sein de la figure 4, cet encastrement est rendu possible par la structure même de l'écran. En effet, celui-ci présente au niveau du bord du diaphragme un épaulement destiné à venir se positioner sur les chants du circuits de détection.

Selon une caractéristique avantageuse de l'invention, l'écran-diaphragme (12) conforme à l'invention est réalisé par électroformage. En effet, cette technique par ailleurs connue, permet la réalisation de pièces de très petite dimension avec une grande précision. L'électroformage est un procédé d'obtention de pièces formées directement par électro-déposition sur un moule. Ainsi, un écran assujetti au circuit de détection présente des dimensions voisines voire légèrement supérieures au circuit et en tout état de cause nettement plus faibles que les écrans de l'art antérieur, compte tenu que dans ce dernier cas, ils devaient circonscrire tous les éléments de l'assemblage à savoir respectivement, circuit de détection proprement dit, circuit de lecture et d'exploitation, plaque de connectique et plan froid. De plus, le choix de cette méthode de fabrication rend possible la fabrication de pièces présentant deux épaisseurs différentes telles que l'écran-diaphragme conforme à l'invention. En effet, la périphérie de ce dernier présente une épaisseur typique de 100 micromètres alors que la zone centrale en appui sur le circuit de détection ne présente qu'une épaisseur de 10 micromètres, pour un circuit de détection rectangulaire de dimensions 3 mm x 8 mm. Cette configuration à deux épaisseurs permet ainsi de conférer une certaine rigidité à l'écran pour un accroissement de masse minimum. De plus, il facilite l'encastrement et le positionnement de l'écran tout en augmentant la précision de positionnement, puisque réalisé uniquement par rapport au chant du circuit de détection.

Il est également possible de réaliser l'écran conforme à l'invention à partir d'un composite de plusieurs métaux, toujours par une technique d'électroformage. Dans ce cas, les métaux utilisés sont principalement le nickel, le cuivre, l'argent ou l'or, le choix parmi ces métaux s'effectuant en fonction des nécessités spécifiques de chaque type de dispositif (adaptation des coefficients de dilatation, conductibilité thermique...). Comme déjà dit, le procédé d'électroformage permet également la fabrication d'écran à structure composite constitué d'empilements de couches de métaux différents.

Enfin, les écrans réalisés par électroformage et conformes à l'invention peuvent être noircis par exemple par anodisation, réduisant encore davantage les rayonnements parasites.

La présente invention apporte de nombreux avantages par rapport aux dispositifs connus à ce jour.

Tout d'abord, la structure d'un tel écran permet d'assembler ledit écran sur le circuit de détection avant de déposer l'ensemble dans le cryostat. Ainsi,l'invention permet d'indexer et de positionner cet écran par rapport à la zone de détection sur un autre site que le doigt froid de l'enceinte cryogénique. Il en résulte d'une part une grande facilité et une grande liberté d'exécution, et d'autre part une plus grande précision de positionnement par rapport à la zone de détection compte tenu que les incertitudes relatives au doigt froid, et à l'ensemble des céramiques de connectique et au circuit de lecture et d'exploitation sont alors sans incidence.

De plus, un tel écran permet de s'affranchir des liaisons mécaniques latérales vers le doigt froid du cryostat, laissant ainsi intact et disponible cet espace latéral pour tout autre usage et notamment usage de connectique.

La suppression de l'espace entre écran et circuit de détection, rend totale l'occultation du rayonnement parasite pour la partie du circuit ainsi masquée, tendant à permettre l'obtention de résultats proches de la perfection théorique.

Le contact intime circuit de détection-écran confère à ce dernier une température très proche de celle du détecteur, résultat irréalisable avec tous les dispositifs connus jusqu'alors. De même, cette disposition associée à une faible masse assure une descente en froid des plus rapide.

De plus, la réalisation d'un tel écran par la technique de l'électroformage permet la réalisation d'un écran ayant une géométrie parfaitement définie avec une très grande précision. De plus, l'épaisseur du masque obtenu par électroformage est parfaitement controlable. En outre, la réalisation d'un masque à deux zones d'épaisseur rend possible un encastrement et une auto-indexation de l'écran sur le circuit de détection.

La nature du matériau de l'écran est variable selon le système recevant l'écran. On peut ainsi adapter les différents paramètres, en particulier les coefficients de dilatation et de haute conductibilité thermique. Enfin, la réalisation de tels écrans par électroformage réduit sensiblement les coûts et le poids tout en augmentant la précision.

## Revendications

1. Dispositif de détection infrarouge fonctionnant à une température comprise entre 50 et 130 K, comprenant :
- un cryostat muni d'un doigt froid (1), destiné à assurer un échange thermique avec une source froide ;
- un plan froid (2) disposé de manière générale perpendiculairement par rapport au doigt froid (1) et en relation d'échange thermique avec ce dernier ;
- un circuit de lecture et d'exploitation (8) associé à un circuit de connexion (3) fixé au-dessus dudit plan froid (2) et en relation d'échange thermique avec ce dernier ;
- un circuit de détection (9), parallèle audit circuit de lecture et d'exploitation (8), fixé mécaniquement et connecté électriquement et thermiquement à ce dernier au moyen de microbilles d'Indium (10) ;
- un écran (12) muni d'une fenêtre formant diaphragme situé entre le circuit de détection (9) et la source de rayonnement à infrarouge ;
caractérisé en ce que l'écran (12) est plaqué contre le circuit de détection (9) et n'est en relation d'échange thermique qu'avec ce dernier.

2. Dispositif de détection infrarouge selon la revendication 1, caractérisé en ce que l'écran (12) est positionné sur le circuit de détection (9) et est encastré sur les chants dudit circuit.

3. Dispositif selon l'une des revendications 1 et 2, caractérisé en ce que l'écran (12) est assujetti sur le circuit de détection (9) par collage.

4. Dispositif de détection infrarouge selon l'une des revendications 1 à 3, caractérisé en ce que l'écran (12) est formé par électroformage d'un métal unique.

5. Dispositif de détection infrarouge selon l'une des revendications 1 à 4, caractérisé en ce que la structure de l'écran (12) est du type composite, réalisé par électroformage de plusieurs métaux.

6. Dispositif de détection infra-rouge selon l'une des revendications 4 et 5, caractérisé en ce que les métaux entrant dans la structure de l'écran (12) sont choisis dans le groupe comprenant le nickel, le cuivre, l'argent et l'or.

7. Dispositif de détection infrarouge selon l'une des revendications 1 à 6, caractérisé en ce que l'écran (12) est noirci par anodisation.

## Patentansprüche

1. Infrarot-Detektionsvorrichtung zum Betrieb bei einer tiefen Temperatur zwischen 50 und 130 K mit
- einem mit einem Kältefinger (1) versehenen Kryostaten zum Herstellen eines thermischen Austausches mit einer Kältequelle,
- einer kalten platte (2), die im wesentlichen rechtwinklig zu dem Kältefinger (1) angeordnet ist und im thermischen Austausch mit diesem steht,
- einem mit einen Anschlußkreis (3) verbundenen Auslese- und Auswertekreis (8), der über der kalten platte (2) befestigt ist und mit der letzteren im thermischen Austausch steht,
- einem Detektionskreis (9), der parallel zu dem Auslese- und Auswertekreis (8) ist und mechanisch befestigt sowie elektrisch und thermisch mit dem letzteren mittels Mikrokugeln aus Indium (10) verbunden ist und
- einer mit einem ein Diaphragma bildendes Fenster versehenen Abschirmung (12), die zwischen dem Detektionskreis (9) und der Quelle der Infrarotstrahlung angeordnet ist,
dadurch gekennzeichnet, daß die Abschirmung (12) auf den Detektionskreis (9) aufgelegt ist und nur mit diesem im thermischen Austausch steht.

2. Infrarot-Detektionsvorrichtung nach Anspruch 1, dadurch gekennzeichnet, daß die Abschirmung (12) auf dem Detektionskreis (9) angeordnet ist und auf die Kanten des Kreises eingefügt ist.

3. Vorrichtung nach einem der Ansprüche 1 und 2, dadurch gekennzeichnet, daß die Abschirmung (12) mit dem Detektionskreis (9) durch Verklebung verbunden ist.

4. Infrarot-Detektionsvorrichtung nach einem der Ansprüche 1 bis 3, dadurch gekennzeichnet, daß die Abschirmung (12) durch Galvanoformung eines einzigen Metalles gebildet ist.

5. Infrarot-Detektionsvorrichtung nach einem der Ansprüche 1 bis 4, dadurch gekennzeichnet, daß die Struktur der Abschirmung (12) nach Art eines Verbundes ist, der durch Galvanoformung mehrerer Metalle hergestellt ist.

6. Infrarot-Detektionsvorrichtung nach einem der Ansprüche 4 und 5, dadurch gekennzeichnet, daß die in der Struktur der Abschirmung (12) eingehenden Metalle aus der Nickel, Kupfer, Silber und Gold aufweisenden Gruppe ausgewählt sind.

7. Infrarot-Detektionsvorrichtung nach einem der Ansprüche 1 bis 6, dadurch gekennzeichnet, daß die Abschirmung (12) durch anodische Oxidation geschwärzt ist.

## Claims

1. An infrared detection device operating within a range between 50 and 130 K, comprising:
- a cryostat equipped with a cold finger (1) intended to provide a heat exchange with a cold source ;
- a cold plane (2) disposed generally perpendicularly in relation to the cold finger (1) and in heat exchange relation with the latter;
- a read and application circuit (8) associated with a connection circuit (3) fixed above said cold plane (2) and in heat exchange relation with the latter;
- a detection circuit (9), parallel to said read and application circuit (8), fixed mechanically and connected electrically and thermally to the latter by means of Indium microspheres (10) ;
- a screen (12) equipped with a window forming a diaphragm situated between the detection circuit (9) and the source of infrared radiation ;
wherein the screen (12) is pressed against the detector circuit (9) and is in heat exchange relation only with the latter.

2. The infrared detection device as claimed in claim 1, wherein the screen (12) is positioned on the detection circuit (9) and is force-fitted on the edges of said circuit.

3. The device as claimed in one of claims 1 and 2, wherein the screen (12) is secured on the detection circuit (9) by adhesive bonding.

4. The infrared detection device as claimed in one of claims 1 to 3, wherein the screen (12) is formed by electroforming of a single metal.

5. The infrared detection device as claimed in one of claims 1 to 4, wherein the structure of the screen (12) is of the composite type, formed by electroforming of a plurality of metals.

6. The infrared detection device as claimed in one of claims 4 and 5, wherein the metals included in the structure of the screen (12) are selected from within the group comprising nickel, copper, silver and gold.

7. The infrared detection device as claimed in one of claims 1 to 6, wherein the screen (12) is blackened by anodization.
